(19) **Europäisches Patentamt**

**European Patent Office**

**Office européen des brevets**

(11) **EP 1 142 120 B1**

(12) **EUROPEAN PATENT SPECIFICATION**

(45) Date of publication and mention
of the grant of the patent:
**05.07.2006 Bulletin 2006/27**

(51) Int Cl.:
*H03L 7/085* (2006.01)    *H03L 7/087* (2006.01)
*H04L 7/033* (2006.01)

(21) Application number: **99965313.2**

(22) Date of filing: **17.12.1999**

(86) International application number:
**PCT/US1999/030205**

(87) International publication number:
**WO 2000/038324 (29.06.2000 Gazette 2000/26)**

(54) **PLL AND GAIN CONTROL FOR CLOCK RECOVERY**

PHASENREGELSCHLEIFE UND VERSTÄRKUNGSREGELUNG ZUR TAKTRÜCKGEWINNUNG

BOUCLE A PHASE ASSERVIE ET COMMANDE DE GAIN POUR RECUPERATION DE SIGNAUX D'HORLOGE

(84) Designated Contracting States:
**DE FR GB IT**

(30) Priority: **22.12.1998 US 218382**
**02.07.1999 US 347256**

(43) Date of publication of application:
**10.10.2001 Bulletin 2001/41**

(73) Proprietor: **Xilinx, Inc.**
**San Jose, California 95124-3400 (US)**

(72) Inventors:
• **GRUNG, Bernard, L.**
**Eden Prairie, MN 55347 (US)**
• **ROBINSON, Moises, E.**
**Austin, TX 78759 (US)**
• **CHEN, Yiqin**
**Ames, IA 50010 (US)**

(74) Representative: **Freeman, Jacqueline Carol**
**W.P. THOMPSON & CO.**
**55 Drury Lane**
**London WC2B 5SQ (GB)**

(56) References cited:
**EP-A- 0 595 632**       **EP-A- 0 856 946**
**US-A- 5 483 180**       **US-A- 5 574 756**

• **LIN WU ET AL.: "A low jitter 1.25 GHz CMOS analog PLL for clock recovery" PROCEEDINGS OF THE 1998 IEEE INTERNATIONAL SYMPOSIUM ON CIRCUITS AND SYSTEMS, ISCAS '98, [Online] vol. 1, 31 May 1998 (1998-05-31) - 3 June 1998 (1998-06-03), pages 167-170, XP002135219 ISBN: 0-7803-4455-3 Retrieved from the Internet: < URL:http://iel.ihs.com:80/cgi-bin/iel_cgi ? sess=402330179&prod=IEL&page=%2fiel4%2f5 6 27%2f15106%2f00704228%2epdf> [retrieved on 2000-04-10]**
• **LIN, J. Y. ET AL.: "Design of clock recovery MMIC using large-signal computer-aided analysis" MICROWAVE SYMPOSIUM DIGEST, 1995, IEEE MTT-S INTERNATIONAL, [Online] vol. 3, 1995, pages 1181-1184, XP002135220 ISBN: 0-7803-2581-8 Retrieved from the Internet: < URL:http://iel.ihs.com:80/cgi-bin/iel_cgi ? sess=402330179&prod=IEL&page=%2fiel2%2f3 2 19%2f9124%2f00406182%2epdf> [retrieved on 2000-04-10]**

**Description**

Technical Field of the Invention

The present invention relates generally to clock recovery and in particular the present invention relates to phase lock loop, transconductance circuitry and gain control circuitry for recovering a clock from high data rate signals.

Background of the Invention

Clock and data recovery in high speed data communication systems require receiver circuits which can adjust an internal oscillator to a frequency and phase of the communicated data. For a description of clock recovery, see C. R. Hogge, "A Self Correcting Clock Recovery Circuit," IEEE, J. Lightwave Technol. LT-3 1312 (1985). Hogge describes a receiver circuit which adjusts a recovered clock signal to center the clock signal transitions in a center of the communicated data signal. U.S. Patent No. 5,448,598 discloses a data receiver according to the preamble of claim 1.

Other references include Lin Wu et al. "A Low Jitter 1.25 GHz CMOS Analog PLL for Clock Recovery" Procedings of the 1998 IEEE International Symposium on Circuits and Systems, ISCAS '98, Vol. 1, 31 May 1998 (1998-05-31), 3 June 1998, pp. 167-170, and EP-A-0 856 946 A2.

The receiver circuits typically require a phase lock loop circuit to acquire the clock signal from the transmitted data. Phase lock loop circuits adjust an internal oscillator to match a phase of an externally supplied reference signal, such as the received data signal. These phase lock loop circuits compare the reference signal to the internal oscillator signal and provide an output which is used to adjust the oscillator. For example, a parallel digital phase lock loop architecture is described in Fiedler et al., "A 1.0625 Gbps Transceiver with 2x-Oversampling and Transmit Signal Pre-Emphasis," ISSCC 1997 Dig. Tech. Papers, 238 (1997).

High speed data recovery in a communication system operating in excess of 1 GHz requires high speed components, a speed which is difficult to achieve in complementary metal oxide semiconductor (CMOS) fabrication. In particular, current CMOS fabrication sizes of about 0.18 to 0.35 micron have NMOS transistors with a frequency cutoff $f_1$ of about 10 to 15 GHz. Thus, processing a signal with a frequency of about 1.25 GHz pushes the transistors to their limitations. Further, gain control in a conventional receiver circuit adjusts the input signal prior to processing with a phase lock loop. Using CMOS processing, accurately adjusting the gain of the high frequency input data is not presently possible. The economics of IC fabrication create a need for a solution to high speed clock recovery using CMOS technology.

For the reasons stated above, and for other reasons stated below which will become apparent to those skilled in the art upon reading and understanding the present specification, there is a need in the art for a CMOS receiver circuit capable of recovering a clock signal and data in a high speed data communication system. Further, there is a need for a receiver which can adjust gain to changes in the communication data voltage.

Summary of the Invention

The above mentioned problems with high speed data communication receiver circuits and other problems are addressed by the present invention and will be understood by reading and studying the following specification.

Brief Description of the Drawings

Figure 1 is a block diagram of a data communication system;
Figure 2 is a diagram of a dual loop phase lock loop circuit of one embodiment of the present invention;
Figure 3 is a diagram of a fine loop circuit;
Figure 4 is a schematic diagram of a transconductance circuit;
Figure 5 is a diagram of a coarse loop circuit;
Figure 6A is a schematic diagram of an input stage for a transconductor;
Figure 6B is a graph illustrating operation of the input stage of Figure 6A;
Figure 7A is a block diagram of a dual transconductance circuit;
Figure 7B is a graph illustrating operation of the dual transconductance circuit of Figure 7A;
Figure 8 is one embodiment of a transconductance circuit including an automatic gain control circuit;
Figure 9 is another embodiment of a transconductance circuit including an automatic gain control circuit;
Figure 10 illustrates a block diagram of an envelope detector circuit;
Figure 11 illustrates one embodiment of a positive peak detector circuit; and

Figure 12 illustrates one embodiment of a negative peak detector circuit.

Detailed Description of the Invention

In the following detailed description of the preferred embodiments, reference is made to the accompanying drawings which form a part hereof, and in which is shown by way of illustration specific preferred embodiments in which the inventions may be practiced. These embodiments are described in sufficient detail to enable those skilled in the art to practice the invention, and it is to be understood that other embodiments may be utilized and that logical, mechanical and electrical changes may be made without departing from the spirit and scope of the present inventions. The following detailed description is, therefore, not to be taken in a limiting sense, and the scope of the present invention is defined only by the appended claims.

The term "serial" is used here to define a receiver architecture for which the clock recovery and the data recovery are accomplished at the full data rate, for example 1.25 Gb/s. The serial approach requires circuits to operate with a 1.25 GHz clock rate - a requirement that is very difficult to achieve with a 0.25 or 0.35 $\mu$m CMOS integrated circuit fabrication process.

The term "parallel" is used here to define a receiver architecture where the input data stream is sampled at a sampling rate of at least the full data rate, such as 1.25 Gb/s or greater, and the sampled data is processed in several parallel paths. Each path can then operate with a relaxed clock rate compared to the serial approach.

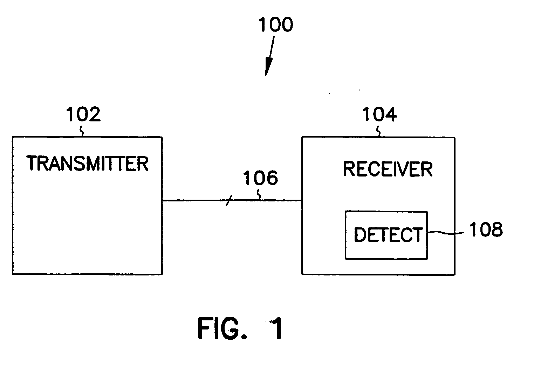

Referring to Figure 1, a communication system 100 is described which operates at high communication speeds. The system includes transmitter 102 and receiver 104 units. The data connections 106 between the transmitter and the receiver units can operate at data rate speeds of about 1.25 Gb/s or greater. The data connections 106 do not include a clock line for synchronizing the receiving units with the transmitting units, but can include complementary data lines. As such, the receiving units include detection circuitry 108 for recovering the clock signal from the received data. In one embodiment, the detection circuitry includes a dual loop phase lock loop (PLL) circuit connected to receive the incoming data signals. The dual loop function allows frequency acquisition with a coarse loop and precise phase control with a fine loop. The receiver, in one embodiment, includes a transconductance function with a small value, such as about 10 $\mu$S (microSiemens). Further, a variable gain function can be provided in the phase lock loop circuit to allow for variable input signal voltages.

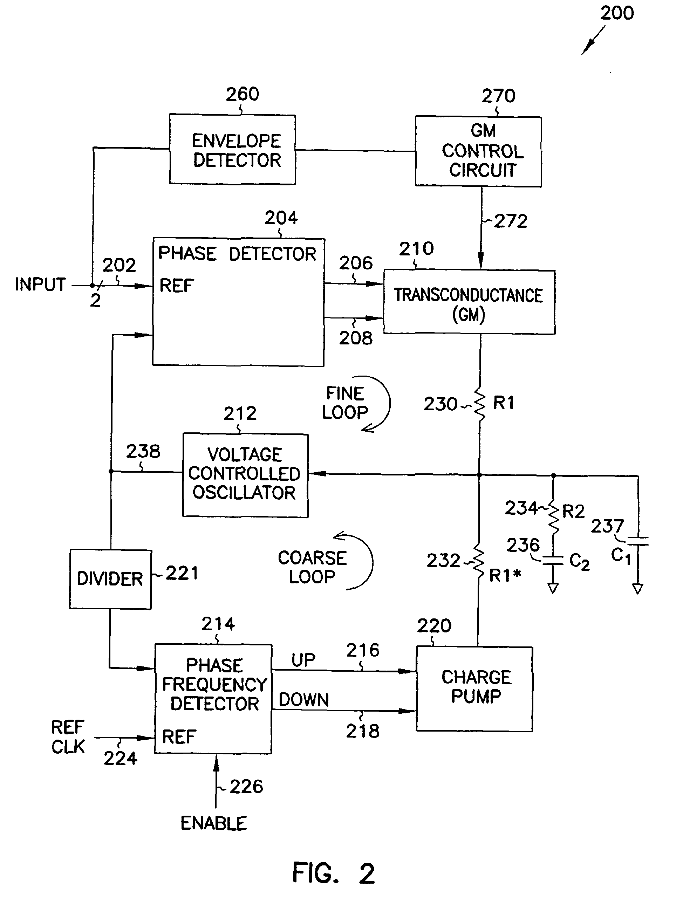

Figures 2-9 illustrate different embodiments of phase lock loop circuits and transconductance circuitry. The basic phase lock loop circuit 200 includes a coarse loop, a fine loop, an envelope detector 260 and transconductance control circuitry 270 to control the value of the transconductance in the fine loop (Figure 2). The transconductance control circuitry provides a control output on connection 272, and embodiments of the envelope detector and transconductance control circuitry are described in greater detail below. The fine loop uses a phase detector 204 which provides differential analog voltage outputs 206 and 208, $Vi_P$ and $Vi_N$, respectively. The fine loop processes the input data provided on complimentary data lines 202, as the phase reference for phase detector 204. The analog outputs of the phase detector are converted to an analog current by a unique transconductance circuit 210. The analog output current is coupled to a voltage controlled oscillator (VCO) 212. The VCO can be any kind of oscillator, including but not limited to a ring oscillator. The VCO is coupled to a second input of the phase detector. In operation, the fine loop adjusts the VCO signal to correspond to the phase of the input data. In one embodiment, the voltage controlled oscillator 212 is a five-stage ring oscillator which is tapped to provide ten output clock signals with the same frequency, but different phases.

The coarse PLL uses a reference clock signal 224, for example 62.5 MHZ, as a frequency reference for a phase-frequency detector (PFD) 214 for rapid frequency acquisition. The PFD is coupled to a charge pump circuit 220 which in turn adjusts an input voltage of voltage controlled oscillator 212. As illustrated, VCO 212 is shared between the coarse and fine loops of the phase lock loop circuit.

A detailed description of the phase lock loop circuitry is provided in the following paragraphs. The phase lock loop circuit is broken into two halves, the fine and coarse loops. A description of the fine loop circuitry is first provided, followed by the coarse loop.

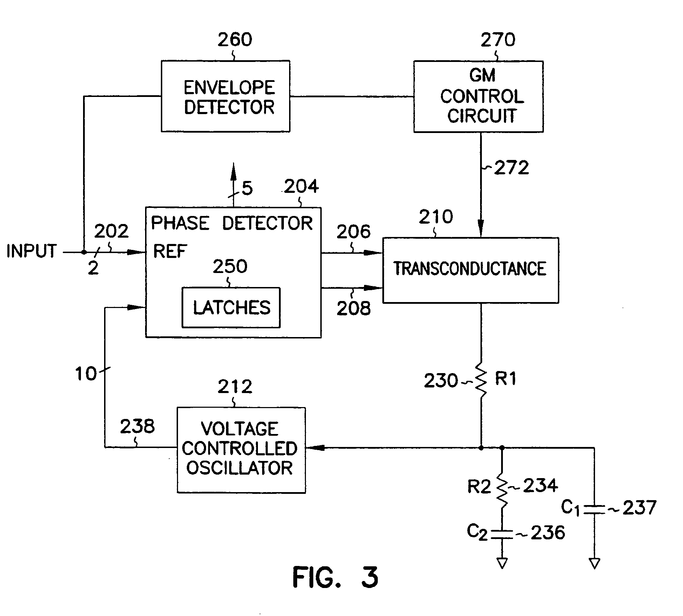

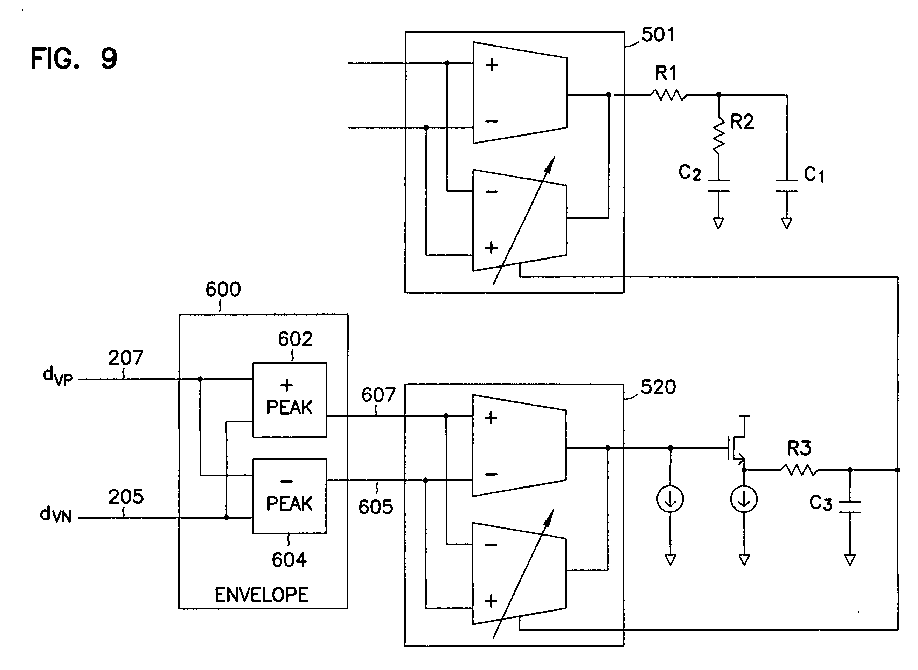

A schematic diagram of the fine PLL circuitry is given in Figure 3. The phase detector (PD) 204 oversamples the input data by a factor of 2 and provides 5 parallel data outputs at 1/5 the input data rate. Input data lines 202 comprise complementary data lines. The complementary data lines are referred to as a negative data connection (dvn) 205 and a positive data connection (dvp) 207, shown in Figures 9-12 below. The terms positive and negative define a relation between the two connections, and do not represent a sign of the magnitude of the data signal provided thereon. Ten high-speed capture latches 250 are used to convert the serial input data into parallel data paths. That is, the input data is sampled twice per data bit. One sample is in the middle of the data period and the other sample is at the edge of the data period. The edge sample is used to adjust the phase of the PLL circuit, and the middle sample is used as one of the five parallel data outputs.

The five middle samples are also used as a logic function to determine the validity of the edge samples. When two adjacent middle samples have the same value, then the intervening edge sample is invalid and is rejected. When two adjacent middle samples differ in value, then the magnitude of the intervening edge sample is valid and the sign of the value needs to be determined. A positive sign is used for a positive transition, and a negative sign is used for a negative transition. When valid, the resulting edge sample is proportional to the phase error.

When the input data is provided at 1.25 Gb/s, each path operates with a 0.250 GHz clock. The PD, therefore, produces a complementary pair of analog voltage outputs 206 and 208 which have a differential voltage proportional to the phase error between the input data and a clock running at 5 times the voltage controlled oscillator frequency.

The transconductance circuit 210 converts this differential analog voltage to an analog current which passes through resistors 230 (R1) and 234 (R2) and which changes the charge on capacitor 236. An optional capacitor 237 can be coupled to resistor 234. The voltage divided by resistors 230 and 234 controls the oscillator 212 input voltage. The effective one-sided transconductance of the transconductance circuit is about 10 $\mu$S for a 1 V peak-to-peak single-ended input signal. Thus, a 1-V, single-sided, peak-to-peak error voltage produces a difference voltage of 2 V peak-to-peak and a 20 $\mu$A peak-to-peak output current ($\pm$10 $\mu$A peak current centered around 0 A). The operation of the fine PLL can be described by:

$$\omega_N = \sqrt{\frac{K_O \, 4 S g_m T_B}{\pi \, C_2}} \qquad (1)$$

and

$$\zeta = \frac{\omega_N}{2} R_2 C_2 \qquad (2)$$

where $\omega_N$ is the natural frequency and $\zeta$ is the damping factor. In addition $K_O$ is the VCO gain, S is the maximum slew rate of the input to the phase detector, $g_m$, is the one-sided transconductance of the transconductor circuit, $T_B$ is the bit period, $R_2$ is the filter resistance and $C_2$ is the filter capacitance. Typical values of $\omega_N$ and $\zeta$ are 3.12 x $10^7$/s and 0.7, respectively. For these values, $K_O$ = 2.43 x $10^9$/s, S = 2V/ns, $g_m$, = 10 uS, $T_B$ = 0.8 ns, $R_2$ = 900 ohms, and $C_2$= 50 pF.

An important element in the receiver circuit 200 is the transconductance circuit 210 which must convert a 1 V single-sided error voltage signal into a current of approximately 10 pA for controlling the voltage controlled oscillator 212. In one embodiment, the transconductance circuit 210 also provides variable gain amplification, as described below. The transconductance circuit contains, a double-sided to single-sided converter, source degeneration resistors to reduce overall gain, and current mirrors to reduce the current at the output by a factor of A, also as explained below. In one embodiment, the reduction factor A is equal to 10.

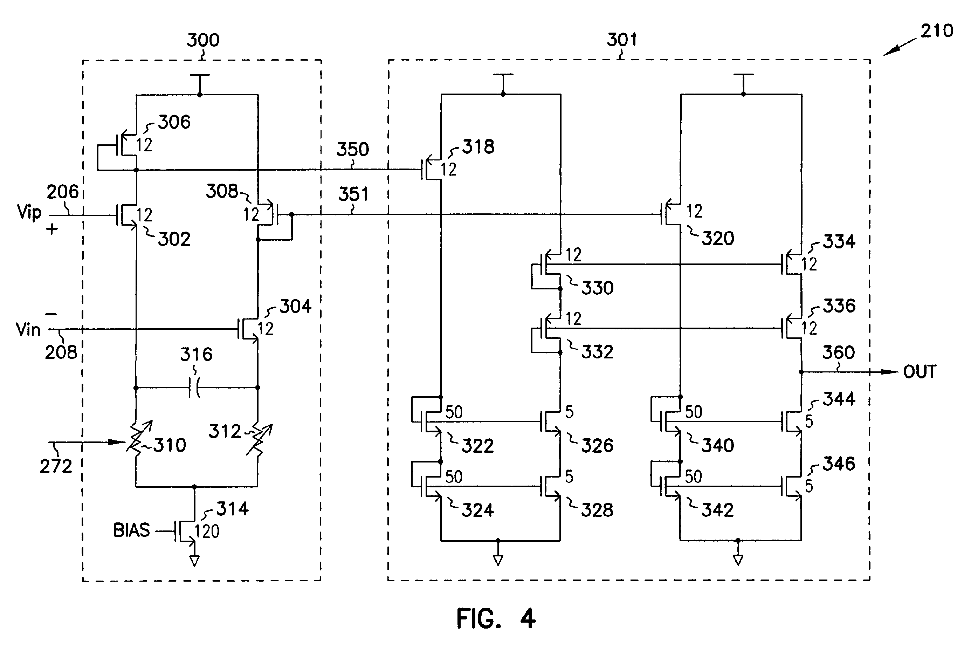

Figure 4, illustrates a schematic diagram of one embodiment of the transconductance circuit. The transconductance circuit has an input stage 300 and an output stage 301. The input stage receives the differential voltage outputs from the phase detector circuit and provides intermediate outputs 350 and 351. The input stage operates as a differential amplifier with active loads (transistors 306 and 308) and degeneration resistors (310 and 312). In one embodiment, degeneration resistors 310 and 312 are variable and controlled by the control output signal on connection 272 from transconductance control circuit 270.

The input stage includes two n-channel input field effect transistors 302 and 304. A diode-connected (drain and gate connected) p-channel transistor 306 is connected between Vdd and the drain of transistor 302. Likewise, a p-channel transistor 308 is connected between Vdd and the drain of transistor 304. The source of transistor 302 is coupled to Vss through resistor 310 and transistor 314, and the source of transistor 304 is coupled to Vss through resistor 312 and transistor 314. An optional capacitor 316 is provided between the sources of transistors 302 and 304. In operation, variations in the differential input voltages on the gates of transistors 302 and 304 change currents through transistors 306 and 308. Thus, voltages on intermediate outputs 350 and 351 also change. The intermediate outputs 350 and 351 are respectively coupled to p-channel transistors 318 and 320, of the output stage 301. The currents through transistors 306 and 308, therefore, are mirrored through transistors 320 and 318.

The output stage 301 provides a low current, high impedance output 360. The output provides a current in response to the linear differential input voltage. The output stage includes a pull-up circuit and a pull-down circuit. The pull-up circuit includes transistors 318, 322, 324, 326, 328, 330, 332, 334 and 336. Series connected n-channel transistors 322 and 324 are connected as diodes (gate coupled to drain) and conduct the same current mirrored in transistor 318.

Transistors 326 and 328 are sized to conduct one-tenth the current of transistors 322 and 324, respectively. Thus, the current through transistors 322 and 324 is mirrored and divided by ten through transistors 326 and 328. This reduced current is mirrored through p-channel transistors 330 and 332 to p-channel transistors 334 and 336. Transistors 334 and 336 are coupled to output node 360 to pull-up the output node and increase the output current.

The output stage pull-down circuit includes transistors 320, 340, 342, 344, and 346. Series connected n-channel transistors 340 and 342 are connected as diodes (gate coupled to drain) and conduct the same current mirrored in transistor 320. Transistors 344 and 346 are sized to conduct one-tenth the current of transistors 340 and 342, respectively. Thus, the current through transistors 340 and 342 is mirrored and divided by ten through transistors 344 and 346. Transistors 344 and 346 are coupled to output node 360 to pull-down the output node and decrease the output current.

In operation, transistor 314 is activated and the differential voltage across the gates of transistors 302 and 304 results in a current output at node 360. Thus, as a voltage on the gate of transistor 302 increases, the current through transistors 334 and 336 increases. Likewise, as a voltage on the gate of transistor 304 increases, the current through transistors 344 and 346 increases.

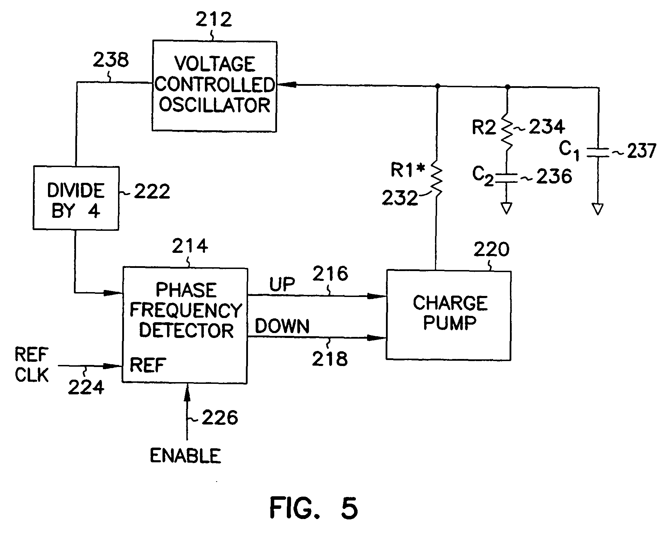

A schematic diagram of the coarse loop is shown in Figure 5. The coarse loop includes a phase frequency detector 214 which uses a reference clock (REF CLK) input 224 and a divided down output of the VCO circuit 212. The output of the VCO circuit is divided by four using divider circuit 222. An enable signal can be provided at input 226 to the phase frequency detector to inhibit the operation of the coarse loop after frequency acquisition by the VCO. The phase frequency detector provides output signals 216 and 218 to control charge pump 220. The charge pump provides an output current through resistor 232 ($R_1$*). Again, this current is coupled to resistor 234, capacitor 236 and the shared oscillator circuit 212. Thus, the coarse loop is used to adjust the frequency of the VCO circuit to the reference clock (REF CLK) 224.

The coarse PLL can be described by:

$$\omega_N^{\cdot} \ = \ \sqrt{\frac{K_O I_P}{2\,\pi C_2 N}} \tag{3}$$

and

$$\zeta^* \ = \ \frac{\omega_N^{\cdot}}{2} R_2 C_2 \tag{4}$$

where $\omega_N$* is the natural frequency and $\zeta$* is the damping factor. The asterisk is used here to identify variables associated with the coarse PLL. The variables $K_O$, $R_1$*, $R_2$ and $C_2$ are similar to those defined for the fine PLL. $I_p$ is the maximum current of the charge pump 220 and N is equal to 4, which corresponds to the divider (Divide by 4) circuit 222. Since both the transconductance 210 and charge pump 220 circuits provide current pulses, resistors $R_1$ and $R_1$* can be made small. For example, the resistances can be 100Ω, or smaller, even zero.

The above described receiver embodiment provides a high speed clock recovery circuit which operates on a 1 V single-sided peak-to-peak input signal. Because the input voltage can vary from 200 mV to 1 V single-sided peak-to-peak, another embodiment of the receiver circuit includes variable gain amplification to increase the one-sided transconductance from about 10 μS to about 50 μS. Before describing a receiver circuit which includes variable gain amplification, it is noted that the high speed data rates and a 0.25 to 0.35 μm CMOS fabrication process does not allow for reliable variable gain amplification at the input of the phase detector 204. Thus, the following embodiments implement a unique variable gain amplifier implemented with the transconductance circuit. It will be understood that in the above described circuitry, the number of latches, data outputs, VCO stages, crystal frequency, magnitude of the transconductance and the divider circuit is not critical to the invention. These numbers can be varied by one skilled in the art, upon reading the present description, without deviating from the present invention.

As described above, the transconductance circuit 210 of Figures 3 and 4 includes an input stage 300 which is configured as a differential amplifier with active/transistor loads (306 and 308) and degeneration resistors (310 and 312). In one embodiment of the transconductance circuit for the Gigabit receiver, a transconductance of about 10 μS is needed for a 1V, single-sided, peak-to-peak voltage. The transconductance should increase to 50 μS when a 200 mV, single-sided peak-to-peak voltage is applied as input to the phase detector 204. A transconductance circuit with an inverse linear relationship between the input voltage magnitude and the transconductance is desired.

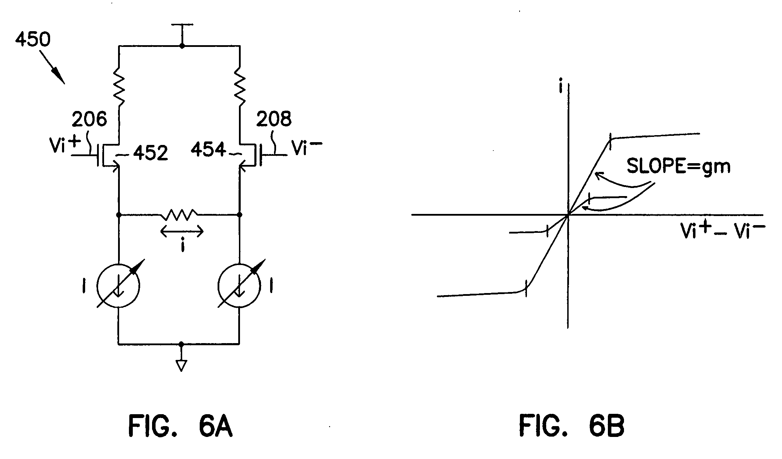

To illustrate a problem with achieving an inverse linear relationship, an example input stage 450 is shown in Figures 6A and 6B. The $g_m$ value of this circuit can be programmed by varying the value of the bias currents I. The linear range for the circuit of Figures 6A and 6B is defined as the region $(V_i^+ - V_i^-)$ where the slope of current I vs $(V_i^+ - V_i^-)$ curve is constant to within a predefined linear specification. This slope is the $g_m$ value:

$$g_m = \left| \frac{i}{V_i^+ - V_i^-} \right| \qquad (5)$$

The linear range of the circuit of Figure 6A is directly proportional to the excess bias voltage of transistors 452 and 454 (vdsat), and vdsat ≈ Vgs -Vt. Where Vgs is the gate to source voltage of transistors 452 and 454, and Vt is the threshold voltage of transistors 452 and 454. The following proportionality relationships hold between the different parameters for circuit 450: linear range ∝ $g_m$ ∝ vdsat ∝ I. Thus, as the $g_m$ value increases, the linear range for circuit 450 increases. Likewise, as the $g_m$ value decreases, the linear range for circuit 450 decreases. This behavior is opposite of what is needed for the fine loop transconductance circuit.

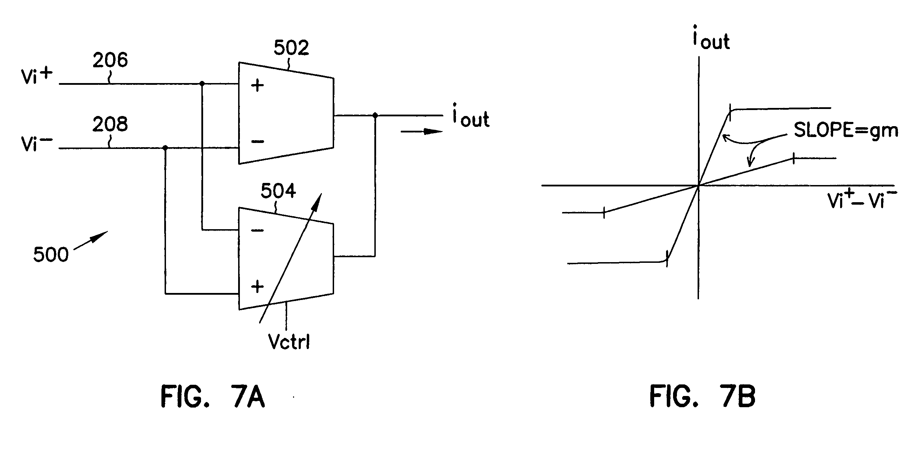

Figures 7A and 7B illustrate a transconductance circuit 500 which has an inverse linear relationship between the input differential voltage and the transconductance. The circuit 500 solves the problem of the relationship between the $g_m$ value and the linear range, but also allows for a large programming range. For a 3V CMOS process, circuit 500 can achieve a programming range of 5X to 10X. Thus, the receiver could support input voltages from 200mV to 1V peak-to-peak single-ended. Transconductance circuit 500 can be used as one embodiment of transconductance circuit 210 of Figure 2.

The circuit of Figure 7A has two (almost identical) transconductance circuits 502 and 504 which are connected in parallel to receive the differential analog voltage inputs. The first transconductor 502 has a fixed transconductance $g_{m1}$, and the second transconductor 504 has a variable transconductance $g_{m2}$. Transconductance circuit 504 has its inputs reversed in comparison to circuit 502. Thus, the overall effective transconductance for the dual circuit approach can be expressed as:

$$g_m = \left| \frac{iout}{V_i^+ - V_i^-} \right| = g_{m1} - g_{m2} \qquad (6)$$

If the transconductance $g_{m1}$ of the first circuit 502 is set at about 100 $\mu$S, and the transconductance $g_{m2}$ of the second circuit 504 varies from about 50 $\mu$S to 90 $\mu$S, the effective transconductance has a 5X range from 10 $\mu$S to 50 $\mu$S. If both transconductance circuits ($g_{m1}$ and $g_{m2}$) use the input stage embodiment 300, shown in Figure 4, the relationship between the $g_m$ (effective) value and linear range of the transconductor is as shown in Figure 7B. The control voltage (vctrl) for transconductor 504 is generated by a control loop that adjusts the voltage according to the magnitude of the receiver input signal 202. It will be recognized by reading the description that a control current ictrl could be used in place of a control voltage. This control loop is referred to as an automatic gain control (AGC) loop, which is described in greater detail in the following section.

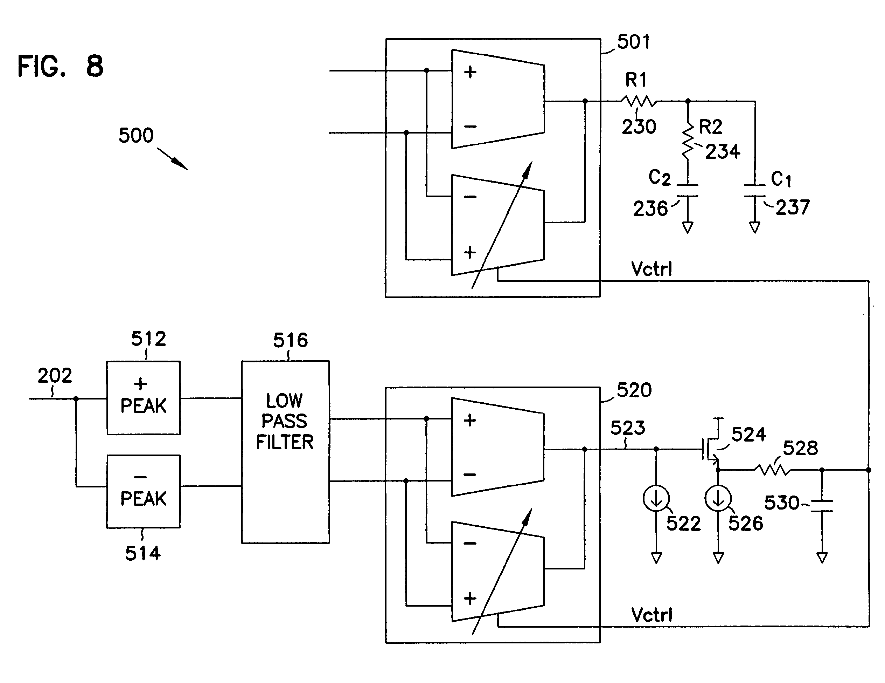

One embodiment of a transconductance circuit 501, having an AGC loop, for the receiver circuit is shown in Figure 8. Transconductance circuit 501 can be used as one embodiment of transconductance circuit 210, and the AGC circuit is one embodiment of envelope detector 260 and GM control circuit 270 of Figure 2. The AGC circuit has two peak detectors 512 and 514 (positive and negative peaks) which are connected to one of the inputs 202, either the positive or negative input, of the fine loop phase detector 204. The output of the peak detectors are coupled to a low pass filter 516, and a low frequency signal (ideally DC) is presented at the input of a master transconductance circuit 520. The value of the low frequency signal is equal to the peak-to-peak voltage of the single-ended input signal on input 202. A 10$\mu$A current source 522 is forced at the output of the master transconductance circuit 520. The loop reacts in such a way as to maintain the product of the input voltage to the master transconductance circuit, multiplied by the transconductance of the master transconductance circuit equal to 10$\mu$A:

$$(\textit{Voltage at the input of circuit } 520) * g_m = 10\mu A \qquad (7)$$

The loop accomplishes this by lowering or raising the control voltage Vctrl. Finally, the same control voltage, Vctrl, controls the value of a slave transconductance circuit 501 in the fine loop PLL, thus producing the desired automatic gain control behavior. The output 523 of transconductance circuit 520 can be used directly as Vctrl. In the embodiment shown, however, transistor 524 and current source 526 are used to level shift the output signal. Likewise, resistor 528 and capacitor 530 are provided to reduce noise on the Vctrl connection. These two circuits (level shift and RC) are optional for signal processing.

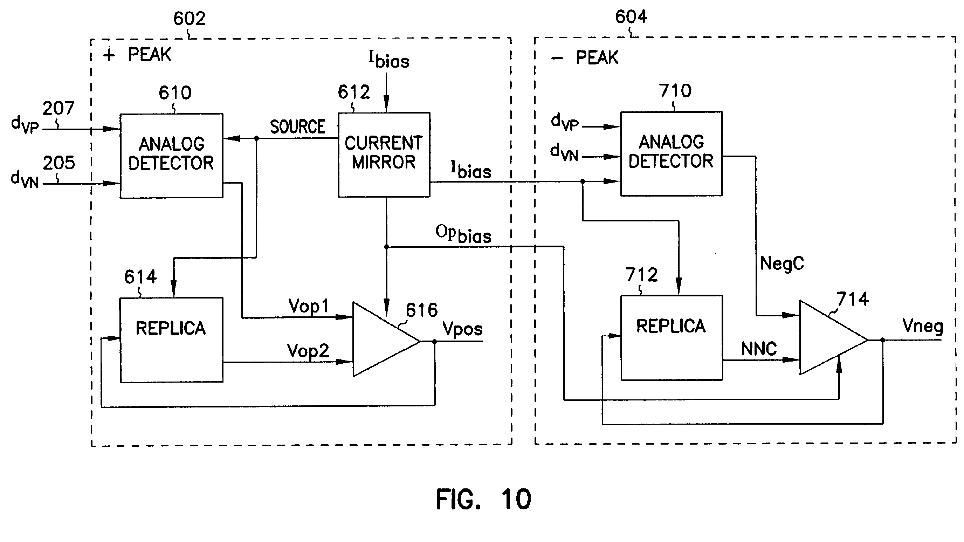

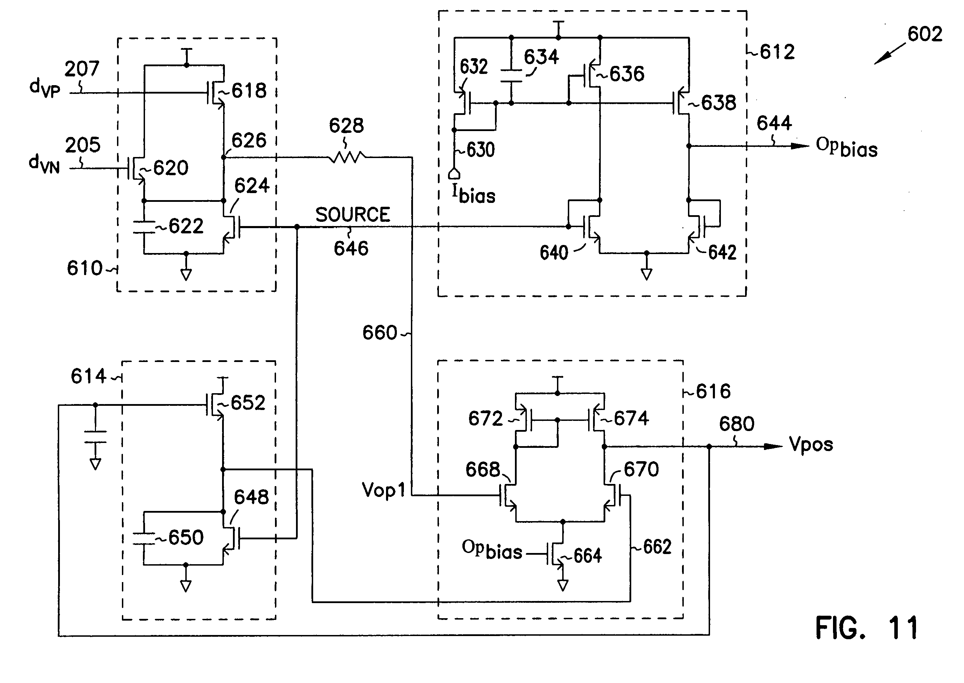

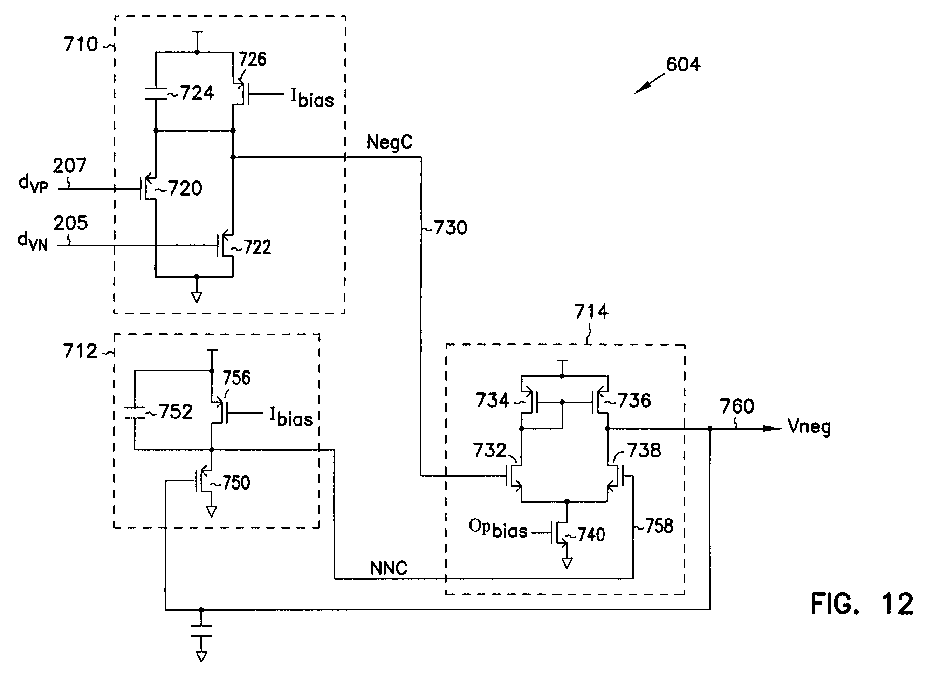

Figure 9 illustrates another embodiment of an automatic gain control circuit which includes master transconductance circuit 520, slave transconductance circuit 501, and an envelope detector circuit 600. The envelope detector is coupled to receive the differential input signals 205 and 207 and provide positive and negative output voltages (on 605 and 607) which represent a voltage envelope of the input signals. The envelope detector includes a positive peak detector 602 and a negative peak detector 604. A detailed description of one embodiment of these peak detectors are provided below with reference to Figure 11 and Figure 12, respectively. A general block diagram of the envelope detector is illustrated in Figure 10.

Referring to Figure 10, the positive peak detector 602 includes an analog peak detector circuit 610, a current mirror circuit 612, a replica analog detector circuit 614, and an amplifier circuit 616. The negative peak detector 604 includes an analog peak detector 710, a replica analog detector circuit 712 and an amplifier circuit 714. Both the positive and negative peak detector circuits share the current mirror circuit 612. For description purposes, therefore, the current mirror circuit is described as being part of the positive peak detector circuit, but could equally be part of the negative detector, or neither circuit.

Figure 11 illustrates one embodiment of the positive peak detector circuit 602. The analog peak detector circuit 610 includes first and second pull-up n-channel transistors 618 and 620. The gate of transistor 618 is coupled to receive the positive input voltage signal 207, and the gate of transistor 620 is coupled to receive the negative input voltage signal 205. As explained above, these input signals are complementary such that when one signal is at its positive peak, the other signal is at its negative peak. The analog peak detector circuit provides a near DC voltage signal at output node 626. The output voltage is referred to as near DC because transistors 618 and 620 are alternately activated, as explained below. By alternately activating the transistors, the output voltage on node 626 will not remained steady. Pull-up transistors 618 and 620 are both coupled to charging capacitor 622. A discharge transistor 624 is coupled to capacitor 622 to control a discharge rate of the capacitor. The gate voltage of transistor 624 is controlled by a regulated source, as explained in greater detail below.

In operation, the analog voltage detector circuit charges capacitor 622 to a voltage equal to the positive voltage peak provided on the differential inputs minus Vt. That is, when the positive input signal activates transistor 618, capacitor 622 is charged to a positive voltage. As the positive input signal decreases and transistor 618 is turned off, the negative input signal begins to activate transistor 620. Capacitor 622, therefore, is charged to a positive voltage via transistor 620. Transistor 624 provides a discharge path for capacitor 622 such that node 626 can track the positive voltage peak of the differential input signals. That is, over time the input amplitude may change and the voltage on capacitor 622 must adjust. It is anticipated that the input signal will vary between 200mV and IV peak-to-peak. The voltage provided on node 626 is coupled to the amplifier circuit input node 660 via a filter resistor 628.

The amplifier circuit 616 includes two inputs, 660 and 662, and an output connection 680. Output connection 680 provides a positive voltage signal which is coupled to the master transconductance circuit 520. The amplifier circuit includes input transistor 668 which controls a current through P-channel transistor 672. The current conducted through transistor 672 is mirrored in P-channel transistor 674. A bias transistor 664 is provided for enabling the amplifier circuit and providing a constant bias current. The voltage on output connection 680 is controlled by transistor 670 and transistor 674. Transistor 670 is controlled by the replica analog detector circuit 614. Transistors 668 and 670 are equal in size, likewise transistors 672 and 674 are equal in size. As explained below, the input voltage on node 660 and the input voltage on node 662 are equal such that the amplifier keeps the voltages at 660 and 662 equal by driving the gate of transistor 652 to be equal to the positive envelope of the input signals at the gates of 618 and 620.

Replica analog detector circuit 614 provides a DC input voltage to amplifier input node 662. The replica circuit includes an n-channel pull-up transistor 652 which is identical to pull-up transistor 618. The pull-up transistor is coupled to a charging capacitor 650 and a discharge transistor 648. The charging capacitor and discharge transistor are identical to capacitor 622 and transistor 624. The gate connection of transistor 652 is coupled to receive the output voltage provided on node 680. In operation, transistor 652 is activated to charge capacitor 650. As capacitor 650 is charged, transistor 670 is activated and pulls node 680 down. This decrease in voltage on node 680 reduces the current conducted through transistor 652. This feedback process, therefore, stabilizes the voltage on node 662 to a voltage which is the DC equivalent of the output of the analog peak detector 610. Because the output of circuit 614 is a steady DC voltage, a filter resistor is not coupled between transistors 652 and the gate connection of transistor 670.

The current mirror circuit 612 provides a controlled voltage level which is coupled to the gate connection of transistors 624 and 648 of the analog peak detector circuits. The current mirror circuit is also referred to herein as a regulator circuit which provides a regulated voltage. The current mirror circuit also provides a regulated bias voltage which is coupled to the gate of transistor 664 of the amplifier circuit. The current mirror circuit includes an input connection 630 for receiving a bias current (Ibias). The bias current is a regulated current provided by a current source (not illustrated). The bias current establishes a current through transistor 632 which is mirrored in transistor 636 and transistor 640. The gate of transistor 640 is coupled to the gates of transistors 624 and 648. By controlling the input bias current at node 630, therefore, a controlled voltage source is provided to control the discharge current of capacitors 622 and 650. The current conducted through transistor 632 is also mirrored in transistors 638 and 642. The voltage at node 644 is coupled to bias transistor 664 of the amplifier to control a bias current of the amplifier circuit. Capacitor 634 is provided to stabilize input node 630 against fluctuations in either the bias current or supply voltage.

Negative peak detector circuit 604 is illustrated in Figure 12. Again, the negative peak detector circuit includes a negative analog detector circuit 710, a replica peak detector circuit 712 and an amplifier circuit 714. The analog peak detector circuit 710 includes p-channel pull-down transistors 720 and 722 which are coupled to receive the positive input signal and the negative input signal, respectively. The pull-down transistors are coupled to capacitor 724. The p-channel pull-up transistor 726 is coupled to capacitor 724 to control a discharge path of the capacitor. This circuit operates in a manner similar to circuit 610 of the positive peak detector, described above. That is, transistors 720 and 722 are alternately activated to provide a voltage on node 730 which approximates the lower peak voltage level of the input signals. The voltage on node 730 is a near DC voltage signal, and does contain fluctuations which result from the activation and deactivation of transistors 720 and 722.

The voltage provided on node 730 is coupled to amplifier circuit 714. Amplifier circuit 714 is identical to amplifier circuit 616 of the positive peak detector circuit. The input voltage on node 730 is coupled to a gate connection of transistor 732, and a current conducted through transistor 732 and transistor 734 is mirrored in transistor 736. The amplifier circuit includes a bias transistor 740 and an n-channel pull down transistors 738. The gate of transistor 738 is coupled to an output connection 758 of replica circuit 712.

The replica circuit includes a pull-down P-channel transistor 750, charging capacitor 752 and a discharge transistor 756. This circuitry is identical in size to transistor 722, capacitor 724 and transistor 726 of the analog peak detector 710. In operation, analog detector 710 provides an output voltage on node 730 which is approximately equal to the lower peak voltage provided on the input connections. This input voltage activates transistor 732 of the amplifier circuit and controls a voltage on node 760. The output voltage on node 760 activates transistor 750 which adjusts the input voltage on node 758. As a result, the voltage on node 758 is stabilized to a voltage which is the DC equivalent of the voltage provided on node 730.

The envelope circuit 600, described above and shown in Figure 9, provides a complimentary pair of voltage output signals whose difference is equal to the envelope of the differential input signals. The output voltage signals are used to control master transconductance circuit 520, illustrated in Figure 9. The master transconductance circuit provides a controlled voltage to slave transconductance circuit 501. The result is an automatic gain control circuit which detects changes in the peak voltage amplitudes of the differential input voltage signals and adjusts a gain of a transconductance circuit such that the output of the slave transconductance circuit is adjusted so that the phase lock loop characteristics are independent of the input signal amplitude.

Conclusion

A high speed data communication system has been described which has a receiver to recover data and clock signals from the communicated data. The receiver circuit has a dual-loop phase lock loop (PLL) circuit. A fine loop of the PLL includes a phase detector having a differential analog voltage output.. Transconductance circuitry has been described which converts the differential analog voltage output to a low current analog output. The transconductance circuitry has a high impedance output, a small transconductance value (~10 to 50 $\mu$S) and has a variable gain control. Gain control circuitry has been described for adjusting the transconductance of the transconductor circuit. A coarse loop of the PLL allows for frequency acquisition of an internal oscillator, or an external reference clock. The gain control circuit includes an envelope detector having a negative and positive detector circuits.

**Claims**

1. A high speed data receiver, comprising differential input connections (202) for receiving differential analog input voltage signals, a phase detector circuit (204) coupled to receive the differential analog input voltage signals and provide a differential analog voltage output (206, 208), an oscillator (212) for providing the second input signal to the phase detector, the receiver **characterized by**:

   a transconductance circuit (210) coupled between the phase detector circuit (204) and the oscillator (212) for converting the differential analog voltage output into an analog output current, the transconductance circuit (210) having an adjustable gain based upon adjusting a voltage of a bias circuit; and

an automatic gain control circuit, comprising an envelope detector (260) and a transconductance control circuit (270), coupled to the transconductance circuit (210) for providing the control voltage signal in response to an amplitude differential of the differential analog input voltage signals.

2. The high speed data receiver of Claim 1, wherein the high speed data receiver further comprises:

a filter network for converting the output current from the transconductance circuit into an analog voltage to be used as input for the oscillator, the oscillator being coupled to the transconductance circuit through the filter network and arranged to provide a second input signal to the phase detector in response to the analog output current.

3. The high speed data receiver of Claim 1, wherein the envelope detector (280) comprises:

a positive peak detector circuit (602) for detecting an upper peak voltage of the differential analog input voltage signals; and
a negative peak detector circuit (604) for detecting a lower peak voltage of the differential analog input voltage signals.

4. The high speed data receiver of Claim 3, wherein the positive (602) or negative (604) peak detector circuit comprises:

an analog peak detector circuit (610; 710);
a replica analog peak detector circuit (614; 712); and
an amplifier circuit (616; 714) coupled to the analog peak detector circuit and the replica analog peak detector circuit.

5. The high speed data receiver of Claim 1, wherein the high speed input data signal has a frequency of about 1.25 GHz.

6. The high speed data receiver of Claim 1, wherein the transconductance circuit (210) varies in a range of about 10 to 100 μS.

7. The high speed data receiver of Claim 1, further comprising:

a phase frequency detector circuit (214) coupled to receive an output of the oscillator (212) and provide an output indicating a frequency difference between the output of the oscillator and a reference clock signal; and
a charge pump circuit (220) for providing an output signal in response to the phase frequency detector circuit (214), the charge pump output signal coupled to an input of the oscillator (212).

8. The high speed data receiver of Claim 7, further comprising a divide circuit (221) coupled between the oscillator (212) and the phase frequency detector (214), the divide circuit arranged to divide the output of the oscillator by a predetermined value.

9. The high speed data receiver circuit of Claim 1, wherein the transconductance circuit (210) comprises a differential input stage having degeneration resistors to reduce transconductance of the transconductance circuit.

10. The high speed data receiver of Claim 9, wherein the transconductance circuit (210) comprises an output stage having current mirrors to reduce a current at the output of the transconductance circuit (210).

11. The high speed data receiver of Claim 1, wherein the high speed input data signal has a frequency of about 1.25 GHz and the oscillator provides ten output signals each having a frequency of about 250 MHZ.

12. A data communication system, comprising:

a transmitter (102) for transmitting high speed data on a communication line; and
a high speed data receiver (104) according to Claim 7, coupled to the communication line for receiving the high speed data and extracting a clock signal.

13. The data communication system of Claim 12, wherein the high speed data has a frequency of about 1.25 GHz and the reference clock signal is about 62.5 MHZ.

14. The data communication system of Claim 12, wherein the high speed input data signal has a frequency of about 1.25 GHz and the oscillator provides ten output signals each having a frequency of about 250 MHZ.

15. A method of operating a receiver (200), comprising the steps of:

receiving differential input signals (202);
generating an analog voltage representing a phase difference between the input signals and a second signal;
converting the analog signal into an analog current using a transconductance circuit (210);
detecting upper and lower peak voltages of the input signals using an envelope detector circuit (260); and
adjusting a gain of the transconductor circuit (210) in response to a differential magnitude between the upper and lower peak voltages.

16. The method of Claim 15, wherein adjusting the gain comprises:

adjusting a transconductance value of a master transconductor circuit (270) in response to the differential magnitude between the upper and low peak voltages to provide either a control voltage or a control current; and
coupling the control voltage or current to the transconductor circuit (210).

**Patentansprüche**

1. Hochgeschwindigkeitsdatenempfänger, der Folgendes umfasst:

Differentialeingangsverbindungen (202) zum Empfangen von analogen Differentialeingangsspannungssignalen, eine Phasendetektorschaltung (204), die zum Empfangen der analogen Differentialeingangsspannungssignale und zum Erzeugen eines analogen Differentialspannungsausgangs (206, 208) geschaltet ist, einen Oszillator (212) zum Anlegen des zweiten Eingangssignals an den Phasendetektor, wobei der Empfänger **gekennzeichnet ist durch**:

eine Transkonduktanzschaltung (210), die zwischen der Phasendetektorschaltung (204) und dem Oszillator (212) geschaltet ist, um den analogen Differentialspannungsausgang in einen analogen Ausgangsstrom umzuwandeln, wobei die Transkonduktanzschaltung (210) eine justierbare Verstärkung auf der Basis der Justage einer Spannung einer Bias-Schaltung hat; und
eine automatische Verstärkungsregelungsschaltung, die einen Hüllkurvendetektor (260) und eine Transkonduktanzregelschaltung (270) umfasst, gekoppelt mit der Transkonduktanzschaltung (210) zum Erzeugen des Regelspannungssignal als Reaktion auf ein Amplitudendifferential der analogen Differentialeingangsspannungssignale.

2. Hochgeschwindigkeitsdatenempfänger nach Anspruch 1, wobei der Hochgeschwindigkeitsdatenempfänger ferner Folgendes umfasst:

ein Filternetzwerk zum Umwandeln des Ausgangsstroms von der Transkonduktanzschaltung in eine analoge Spannung zur Verwendung als Eingang für den Oszillator, wobei der Oszillator über das Filternetzwerk mit der Transkonduktanzschaltung gekoppelt ist und die Aufgabe hat, als Reaktion auf den analogen Ausgangsstrom ein zweites Eingangssignal an den Phasendetektor anzulegen.

3. Hochgeschwindigkeitsdatenempfänger nach Anspruch 1, wobei der Hüllkurvendetektor (280) ferner Folgendes umfasst:

eine Positivspitze-Detektorschaltung (602) zum Erfassen einer oberen Spitzenspannung der analogen Differentialeingangsspannungssignale; und
eine Negativspitze-Detektorschaltung (604) zum Erfassen einer unteren Spitzenspannung der analogen Differentialeingangsspannungssignale.

4. Hochgeschwindigkeitsdatenempfänger nach Anspruch 3, wobei die Positiv- (602) oder Negativ- (604) Spitze-Detektorschaltung Folgendes umfasst:

eine analoge Spitzendetektorschaltung (610; 710);

eine analoge Kopie-Spitzendetektorschaltung (614; 712); und
eine Verstärkerschaltung (616; 714), die mit der analogen Spitzendetektorschaltung und der analogen Kopie-Spitzendetektorschaltung gekoppelt ist.

5. Hochgeschwindigkeitsdatenempfänger nach Anspruch 1, wobei das Hochgeschwindigkeitseingangsdatensignal eine Frequenz von etwa 1 ,25 GHz hat.

6. Hochgeschwindigkeitsdatenempfänger nach Anspruch 1, wobei die Transkonduktanzschaltung (210) in einem Bereich von etwa 10 bis 100 μS variiert.

7. Hochgeschwindigkeitsdatenempfänger nach Anspruch 1, der ferner Folgendes umfasst:

eine Phasenfrequenzdetektorschaltung (214), die zum Empfangen eines Ausgangs des Oszillators (212) und zum Erzeugen eines Ausgangs gekoppelt ist, der eine Frequenzdifferenz zwischen dem Ausgang des Oszillators und einem Referenztaktsignal anzeigt; und
eine Ladungspumpenschaltung (220) zum Erzeugen eines Ausgangssignals als Reaktion auf die Phasenfrequenzdetektorschaltung (214), wobei das Ladungspumpenausgangssignal mit einem Eingang des Oszillators (212) gekoppelt ist.

8. Hochgeschwindigkeitsdatenempfänger nach Anspruch 7, der ferner eine Dividierschaltung (221) umfasst, die zwischen dem Oszillator (212) und dem Phasenfrequenzdetektor (214) geschaltet ist, wobei die Dividierschaltung die Aufgabe hat, den Ausgang des Oszillators durch einen vorbestimmten Wert zu dividieren.

9. Hochgeschwindigkeitsdatenempfängerschaltung nach Anspruch 1, wobei die Transkonduktanzschaltung (210) eine Differentialeingangsstufe mit Degenerationswiderständen umfasst, um Transkonduktanz der Transkonduktanzschaltung zu reduzieren.

10. Hochgeschwindigkeitsdatenempfänger nach Anspruch 9, wobei die Transkonduktanzschaltung (210) eine Ausgangsstufe mit Stromspiegeln umfasst, um einen Strom am Ausgang der Transkonduktanzschaltung (210) zu reduzieren.

11. Hochgeschwindigkeitsdatenempfänger nach Anspruch 1, wobei das Hochgeschwindigkeitseingangsdatensignal eine Frequenz von etwa 1,25 GHz hat und der Oszillator zehn Ausgangssignale jeweils mit einer Frequenz von etwa 250 MHz erzeugt.

12. Datenkommunikationssystem, das Folgendes umfasst:

einen Sender (102) zum Senden von Hochgeschwindigkeitsdaten auf einer Kommunikationsleitung; und
einen Hochgeschwindigkeitsdatenempfänger (104) nach Anspruch 7, der mit der Kommunikationsleitung zum Empfangen der Hochgeschwindigkeitsdaten und zum Extrahieren eines Taktsignals gekoppelt ist.

13. Datenkommunikationssystem nach Anspruch 12, wobei die Hochgeschwindigkeitsdaten eine Frequenz von etwa 1,25 GHz haben und das Referenztaktsignal eine Frequenz von etwa 62,5 MHz hat.

14. Datenkommunikationssystem nach Anspruch 12, wobei das Hochgeschwindigkeitseingangsdatensignal eine Frequenz von etwa 1,25 GHz hat und der Oszillator zehn Ausgangssignale jeweils mit einer Frequenz von etwa 250 MHz erzeugt.

15. Verfahren zum Betreiben eines Empfängers (200), das die Schritte umfasst:

Empfangen von Differentialeingangssignalen (202);
Erzeugen einer analogen Spannung, die eine Phasendifferenz zwischen den Eingangssignalen und einem zweiten Signal repräsentiert;
Umwandeln des analogen Signals in einen analogen Strom mittels einer Transkonduktanzschaltung (210);
Erfassen von oberen und unteren Spitzenspannungen der Eingangssignale mittels einer Hüllkurvendetektorschaltung (260); und
Justieren einer Verstärkung der Transkonduktorschaltung (210) als Reaktion auf eine Differentialgröße zwischen der oberen und der unteren Spitzenspannung.

**16.** Verfahren nach Anspruch 15, wobei das Justieren der Verstärkung Folgendes umfasst:

Justieren eines Transkonduktanzwertes einer Master-Transkonduktorschaltung (270) als Reaktion auf die Differentialgröße zwischen der oberen und der unteren Spitzenspannung zum Erzeugen entweder einer Steuerspannung oder eines Steuerstroms; und
Koppeln der Steuerspannung oder des Steuerstroms mit der Transkonduktorschaltung (210).

**Revendications**

**1.** Un récepteur de données haut débit comprenant des connexions d'entrée différentielles (202) destinées à recevoir des signaux de tension d'entrée analogiques différentiels, un circuit détecteur de phase (204) couplé de façon à recevoir des signaux de tension d'entrée analogiques différentiels et à fournir une sortie de tension analogique différentielle (206, 208), un oscillateur (212) destiné à fournir le deuxième signal d'entrée au détecteur de phase, le récepteur étant **caractérisé par** :

un circuit de transconductance (210) couplé entre le circuit détecteur de phase (204) et l'oscillateur (212) pour convertir la sortie de tension analogique différentielle en un courant de sortie analogique, le circuit de transconductance (210) possédant un gain réglable basé sur le réglage de la tension d'un circuit de polarisation ; et
un circuit de commande de gain automatique, comprenant un détecteur d'enveloppe (260) et un circuit de commande de transconductance (270) couplé au circuit de transconductance (210) de façon à fournir le signal de tension de commande en réponse à un différentiel d'amplitude des signaux de tension d'entrée analogiques différentiels.

**2.** Le récepteur de données haut débit selon la Revendication 1, où le récepteur de données haut débit comprend en outre :

un réseau de filtrage destiné à convertir le courant de sortie du circuit de transconductance en une tension analogique destinée à être utilisée comme entrée de l'oscillateur, l'oscillateur étant couplé au circuit de transconductance par le réseau de filtrage et agencé de façon à fournir un deuxième signal d'entrée au détecteur de phase en réponse au courant de sortie analogique.

**3.** Le récepteur de données haut débit selon la Revendication 1, où le détecteur d'enveloppe (280) comprend :

un circuit détecteur de crête positive (602) destiné à détecter une tension de crête supérieure des signaux de tension d'entrée analogiques différentiels ; et
un circuit détecteur de crête négative (604) destiné à détecter une tension de crête inférieure des signaux de tension d'entrée analogiques différentiels.

**4.** Le récepteur de données haut débit selon la Revendication 3 où le circuit détecteur de crête positive (602) ou négative (604) comprend :

un circuit détecteur de crête analogique (610 ; 710) ;
un circuit détecteur de crête analogique réplique (614 ; 712) ; et
un circuit amplificateur (616 ; 714) couplé au circuit détecteur de crête analogique et au circuit détecteur de crête analogique réplique.

**5.** Le récepteur de données haut débit selon la Revendication 1, où le signal de données d'entrée haut débit possède une fréquence d'environ 1,25 GHz.

**6.** Le récepteur de données haut débit selon la Revendication 1, où le circuit de transconductance (210) varie dans une plage allant environ de 10 à 100 $\mu$S.

**7.** Le récepteur de données haut débit selon la Revendication 1, comprenant en outre :

un circuit détecteur de fréquence-phase (214) couplé de façon à recevoir une sortie de l'oscillateur (212) et à fournir une sortie indiquant une différence de fréquence entre la sortie de l'oscillateur et un signal d'horloge de référence ; et

un circuit de pompe de charge (220) destiné à fournir un signal de sortie en réponse au circuit détecteur de fréquence-phase (214), le signal de sortie de la pompe de charge étant couplé à une entrée de l'oscillateur (212).

8. Le récepteur de données haut débit selon la Revendication 7, comprenant en outre un circuit de division (221) couplé entre l'oscillateur (212) et le détecteur de fréquence-phase (214), le circuit de division étant agencé de façon à diviser la sortie de l'oscillateur par une valeur déterminée.

9. Le circuit de récepteur de données haut débit selon la Revendication 1, où le circuit de transconductance (210) comprend un étage d'entrée différentiel possédant des résistances à dégénérescence destinées à réduire la transconductance du circuit de transconductance.

10. Le récepteur de données haut débit selon la Revendication 9, où le circuit de transconductance (210) comprend un étage de sortie possédant des miroirs de courant destinés à réduire un courant à la sortie du circuit de transconductance (210).

11. Le récepteur de données haut débit selon la Revendication 1, où le signal de données d'entrée haut débit possède une fréquence d'environ 1,25 GHz et l'oscillateur fournit dix signaux de sortie, chacun d'eux possédant une fréquence d'environ 250 MHz.

12. Un système de communication de données comprenant :

   un émetteur (102) pour l'émission de données haut débit sur une ligne de communication ; et
   un récepteur de données haut débit (104) selon la Revendication 7, couplé à la ligne de communication de façon à recevoir les données haut débit et à extraire un signal d'horloge.

13. Le système de communication de données selon la Revendication 12, où les données haut débit possèdent une fréquence d'environ 1,25 GHz et le signal d'horloge de référence est d'environ 62,5 MHz.

14. Le système de communication de données selon la Revendication 12, où le signal des données d'entrée haut débit possède une fréquence d'environ 1,25 GHz et l'oscillateur fournit dix signaux de sortie, chacun d'eux possédant une fréquence d'environ 250 MHz.

15. Un procédé d'exploitation d'un récepteur (200), comprenant les opérations suivantes :

   la réception de signaux d'entrée différentiels (202) ;
   la génération d'une tension analogique représentant une différence de phase entre les signaux d'entrée et un deuxième signal;
   la conversion du signal analogique en un courant analogique utilisant un circuit de transconductance (210) ;
   la détection de tensions de crête supérieure et inférieure des signaux d'entrée au moyen d'un circuit détecteur d'enveloppe (260) ; et
   le réglage d'un gain du circuit de transconductance (210) en réponse une amplitude différentielle entre les tensions de crête supérieure et inférieure.

16. Le procédé selon la Revendication 15, où le réglage du gain comprend les opérations suivantes :

   le réglage d'une valeur de transconductance d'un circuit de transconductance maître (270) en réponse à l'amplitude différentielle entre les tensions de crête supérieure et inférieure afin de fournir soit une tension de commande ou un courant de comnnande ; et
   le couplage de la tension de commande ou du courant de commande avec le circuit de transconductance (210).

100

102

TRANSMITTER

104

RECEIVER

106

DETECT — 108

FIG. 1

200

260

**ENVELOPE DETECTOR**

270

**GM CONTROL CIRCUIT**

~272

204

**PHASE DETECTOR**

REF

202

INPUT

2

206

208

210

**TRANSCONDUCTANCE (GM)**

*FINE LOOP*

212

238

**VOLTAGE CONTROLLED OSCILLATOR**

230~ R1

DIVIDER ~221

*COARSE LOOP*

234~ R2

236 C2

237 C1

232~ R1*

214

**PHASE FREQUENCY DETECTOR**

REF

REF CLK

224

UP 216

DOWN 218

220

**CHARGE PUMP**

~226

ENABLE

# FIG. 2

FIG. 3

FIG. 4

EP 1 142 120 B1

FIG. 5

450

206    208

Vi+    452    454    Vi-

i

I    I

**FIG. 6A**

i

SLOPE=gm

Vi+ - Vi-

**FIG. 6B**

EP 1 142 120 B1

FIG. 7B

FIG. 7A

FIG. 8

EP 1 142 120 B1

FIG. 9

FIG. 10

EP 1 142 120 B1

FIG. 11

EP 1 142 120 B1

FIG. 12

EP 1 142 120 B1